# DEMANDE DE BREVET EUROPEEN

(11) **EP 3 792 556 A1**
(43) Date de publication de la demande: **17.03.2021**
(21) Numéro de dépôt: 19196455.0
(22) Date de dépôt: 10.09.2019
(51) Int. Cl.: F24D 10/00, F24D 19/10

(54) **SYSTEME D'APPOINT POUR UN RESEAU DE DISTRIBUTION D'ENERGIE THERMIQUE BASSE TEMPERATURE**

(71) Demandeur: Apterix SA, 1003 Lausanne (CH)
(72) Inventeur: ORLANDO, David, 1806 St-Légier (CH)
(74) Mandataire: reuteler & cie SA

(57) **Abrégé**

Système d'appoint (4) pour un réseau de distribution à distance d'énergie thermique basse température (réseau anergie) (2) connectée à des installations thermiques d'utilisateurs, comprenant une ou plusieurs pompes à chaleur (5) couplé thermiquement au réseau anergie via un échangeur de chaleur (10a), un ou plusieurs échangeurs de chaleur air-liquide (6) couplé thermiquement à l'air extérieure, et un réseau hydraulique (8) interconnectant les pompes à chaleur (5) à l'échangeur de chaleur (10a) du réseau anergie (2), au moins une des pompes à chaleur étant une pompe à chaleur liquide-air connectée fluidiquement par le réseau hydraulique (8) à au moins un desdites échangeurs de chaleur air-liquide (6). Le système d'appoint comprend en outre un système de mesure, contrôle et régulation (MCR) (13). Le réseau hydraulique comprend des vannes commandées par le système MCR (13) et un circuit hydraulique configurés pour permettre une connexion directe des desdites échangeurs de chaleur air-liquide (6) à l'échangeur de chaleur (10a) du réseau anergie (2).

## Description

La présente invention concerne un réseau d'alimentation et de distribution d'énergie thermique, notamment pour l'alimentation en chaleur ou en froid de bâtiments, par exemple de bâtiments d'un quartier urbain, raccordés au réseau. La présente invention concerne plus particulièrement un système d'appoint pour un réseau de distribution d'énergie thermique basse température.

Il existe des réseaux de distribution d'énergie thermique à distance (appelés aussi des réseaux de chauffage à distance « CAD ») avec les réseaux d'énergie thermique locaux, tenant compte des différences de températures ainsi que les variations de température et des flux des fluides caloporteurs possibles entre les divers réseaux selon les conditions, par exemple les conditions d'usage, météorologiques, et géothermiques.

Il est connu d'utiliser un réseau de distribution d'énergie thermique à distance basse température (dite « réseau Anergie ») et des pompes à chaleur d'utilisateurs connectées sur ce réseau pour des transferts d'énergie thermique entre utilisateurs et le réseau Anergie. Un réseau Anergie comprend typiquement un tube dans lequel circule un fluide caloporteur connecté à une pluralité d'utilisateurs (clients) consommateurs d'énergie et un ou plusieurs producteurs d'énergie. La conciliation des réseaux de distribution d'énergie thermique à distance basse température et des pompes à chaleur d'utilisateurs connectées sur ce réseau Anergie avec une grande résilience et une efficience maximale est difficile à atteindre par les systèmes existants. Dans les systèmes existants, il est crucial de s'assurer que les températures moyennes de fonctionnement des registres terrestres sont positives afin d'éviter le gel du sous-sol, qui aurait des conséquences qui peuvent être très négatives sur le rendement et la résilience du dit réseau de distribution d'énergie thermique.

On connait plusieurs types d'appoint thermique d'énergie renouvelable pour des réseaux de type Anergie afin d'augmenter la résilience et l'efficience du réseau, les plus courants étant de type géothermique, solaire, les nappes phréatiques, les cours d'eau, les lacs, les eaux usées ou des rejets thermiques de processus industriels.

L'appoint géothermique via l'utilisation de sondes géothermique de type verticales est particulièrement utilisé avec un réseau Anergie car le gradient de température est très proche. L'avantage de cette combinaison est de permettre de stocker le surplus saisonnier dans les sondes verticales et de récupérer cette énergie en hiver. Un inconvénient de cette solution est le coût lié aux dites sondes géothermiques et les difficultés de faire du rafraichissement due aux températures de fonctionnement (typiquement de plus de 15 degrés) qui sont trop élevées.

L'appoint solaire thermique est très intéressant aux niveaux des rendements avec un coût acceptable. L'inconvénient principal provient des variations journalières et saisonnières de l'énergie à disposition, et notamment la diminution d'énergie dans la période froide ou cet appoint devient très faible.

L'appoint par nappes phréatiques est également intéressant aux niveaux des rendements mais les coûts, les autorisations ainsi que les fluctuations de débit sont des contraintes importantes au déploiement de cette solution. L'appoint par les cours d'eau et lac rencontre les mêmes difficultés que l'appoint par nappes phréatiques. L'appoint par eaux usées ou rejets thermiques rencontrent les mêmes problèmes que ceux liés à l'appoint par des sources phréatiques.

Dans les cas où ces différents appoints sont insuffisants à réchauffer ledit réseau anergie, l'utilisation d'une chaudière utilisant de l'énergie primaire, renouvelable ou non, est possible. L'inconvénient d'une telle solution est de diminuer la possibilité de chauffer directement les bâtiments qui sont reliés audit réseau anergie, avec cette énergie primaire.

Pour tirer le meilleur rendement d'une chaudière il est préférable d'utiliser un système de cogénération chaleur-force, aussi appelé couplage chaleur-force (CCF), produisant simultanément de chaleur et de l'électricité. L'électricité générée peut être utilisé localement pour alimenter les bâtiments ainsi que les pompes à chaleur. L'inconvénient de cette solution est qu'il est impossible d'utiliser à 100% la partie chaleur et électrique à cause de la variabilité de la demande. Des unités de couplage chaleur-force permettant la variation de puissance diminue cet inconvénient, sans toutefois l'éliminer.

Un objet de l'invention est de fournir un système d'appoint pour un réseau de distribution d'énergie thermique à distance basse température (réseau Anergie) qui pallie les inconvénients des systèmes existants et qui offre une grande résilience et un haut rendement.

Il est avantageux de fournir un système d'appoint pour un réseau Anergie qui est économe à installer.

Il est avantageux de fournir un système d'appoint pour un réseau Anergie qui est robuste, fiable, et économe à maintenir.

Il est avantageux de fournir un système d'appoint pour un réseau Anergie qui est peut-être commandé facilement et à distance.

Des objets de l'invention sont réalisés par un système d'appoint pour un réseau de distribution d'énergie thermique à distance basse température selon la revendication 1.

Les revendications dépendantes décrivent des caractéristiques avantageuses de l'invention.

Dans la présente, on décrit un système d'appoint pour un réseau de distribution à distance d'énergie thermique basse température (réseau anergie) connectée à des installations thermiques d'utilisateurs. Le système d'appoint comprend une ou plusieurs pompes à chaleur couplé thermiquement au réseau anergie via un échangeur de chaleur, un ou plusieurs échangeurs de chaleur air-liquide couplé thermiquement à l'air extérieure, et un réseau hydraulique interconnectant les pompes à chaleur à l'échangeur de chaleur du réseau anergie. Au moins une des pompes à chaleur est une pompe à chaleur liquide-air connectée fluidiquement par le réseau hydraulique à au moins un desdites échangeurs de chaleur air-liquide. Le système d'appoint comprend en outre un système de mesure, contrôle et régulation (MCR).

Selon un aspect de d'invention, le réseau hydraulique comprend des vannes commandées par le système MCR et un circuit hydraulique configurés pour permettre une connexion directe des desdites échangeurs de chaleur air-liquide à l'échangeur de chaleur du réseau anergie.

Dans une forme d'exécution avantageuse, le système d'appoint comprend en outre un système de cogénération d'énergie électrique et thermique, aussi appelé système de couplage chaleur-force (CFF), couplé thermiquement au réseau hydraulique via un échangeur de chaleur.

Dans une forme d'exécution avantageuse, le réseau hydraulique comprend des vannes commandées par le système MCR et un circuit hydraulique configurés pour permettre une connexion directe du système CCF à l'échangeur de chaleur du réseau anergie.

Dans une forme d'exécution avantageuse, le système comprend en outre un réseau de distribution d'énergie thermique haute température (réseau HT) couplé thermiquement au réseau hydraulique via un échangeur de chaleur.

Dans une forme d'exécution avantageuse, le réseau hydraulique comprend des vannes commandées par le système MCR et un circuit hydraulique configurés pour permettre une connexion directe du réseau HT à l'échangeur de chaleur du réseau anergie.

Dans une forme d'exécution avantageuse, le système d'appoint comprend une pluralité desdites pompes à chaleur.

Dans une forme d'exécution avantageuse, les pompes à chaleur sont interconnectées fluidiquement au réseau hydraulique en parallèle, chaque pompe à chaleur étant connectée au réseau hydraulique à travers des vannes commandées individuellement par le système MCR de façon à permettre l'enclenchement individuel de chaque pompe à chaleur indépendamment des autres pompes à chaleur.

Dans une forme d'exécution avantageuse, les échangeurs de chaleur air-liquide comprennent des ventilateurs commandés par le système MCR.

Dans une forme d'exécution avantageuse, le système d'appoint comprend une pluralité desdites échangeurs de chaleur air-liquide.

Dans une forme d'exécution avantageuse, les échangeurs de chaleur air-liquide sont interconnectés fluidiquement au réseau hydraulique en parallèle.

Dans une forme d'exécution avantageuse, le système MCR comprend une pluralité de capteurs de température, incluant au moins un capteur de température fournissant une mesure de température du fluide caloporteur dans le réseau anergie et au moins un capteur de température fournissant une mesure de température de l'air extérieur.

Dans la présente, on décrit aussi un procédé de commande d'un système d'appoint dans lequel les pompes à chaleur sont enclenchées successivement en fonction du besoin en chaleur du réseau anergie.

Dans la présente, on décrit aussi un procédé de commande d'un système d'appoint dans lequel, en période de besoin d'énergie de chaleur, les échangeurs de chaleur air-liquide sont connectés directement à l'échangeur de chaleur du réseau anergie quand la température de l'air extérieur est supérieure à zéro et supérieure à la température mesuré du fluide caloporteur qui circule dans le réseau anergie

D'autres buts et aspects avantageux de l'invention apparaîtront à la lecture des revendications et/ou de la description détaillée ci-après de formes d'exécution de l'invention en relation avec les figures, dans lesquelles :
La Fig. 1 est une vue schématique d'un système de distribution d'énergie thermique selon une forme d'exécution de l'invention ;
La Fig. 2 est une vue schématique d'un système d'appoint d'un réseau de distribution d'énergie thermique basse température selon une forme d'exécution de l'invention ;

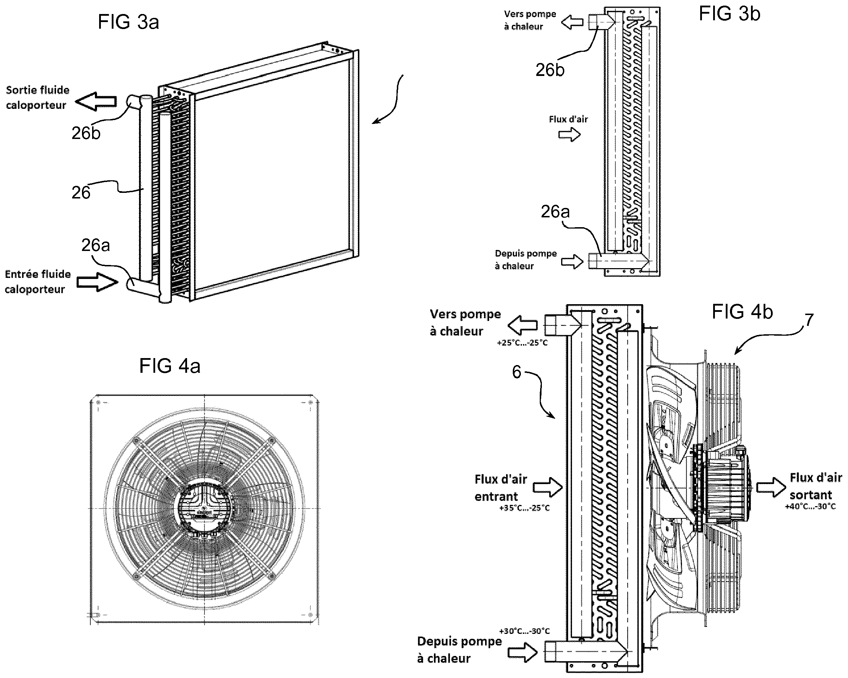

Les Fig. 3a et 3b sont des vues en perspective et de côté d'un échangeur de chaleur air - liquide du système d'appoint selon une forme d'exécution de l'invention ;
Les Fig. 4a et 4b sont des vues de face et de côté d'un échangeur de chaleur air - liquide avec ventilateur du système d'appoint selon une forme d'exécution de l'invention ;
Les Figs 5a à 5h sont des vues schématiques d'un système de distribution d'énergie thermique selon une forme d'exécution de l'invention, illustrant différents modes d'opération ;
Les Figs 6a à 6c sont des graphiques de la température d'évaporation en fonction de la température de condensation de différents fluides caloporteurs pour pompes à chaleur ; Les Figs 7a et 7b illustrent des exemples de variations de température d'un réseau anergie et de l'air extérieur au cours d'une journée ;
La figure 8 illustre un graphique de température de chauffage à la sortie d'une installation de chauffage typique par rapport à la température extérieure.

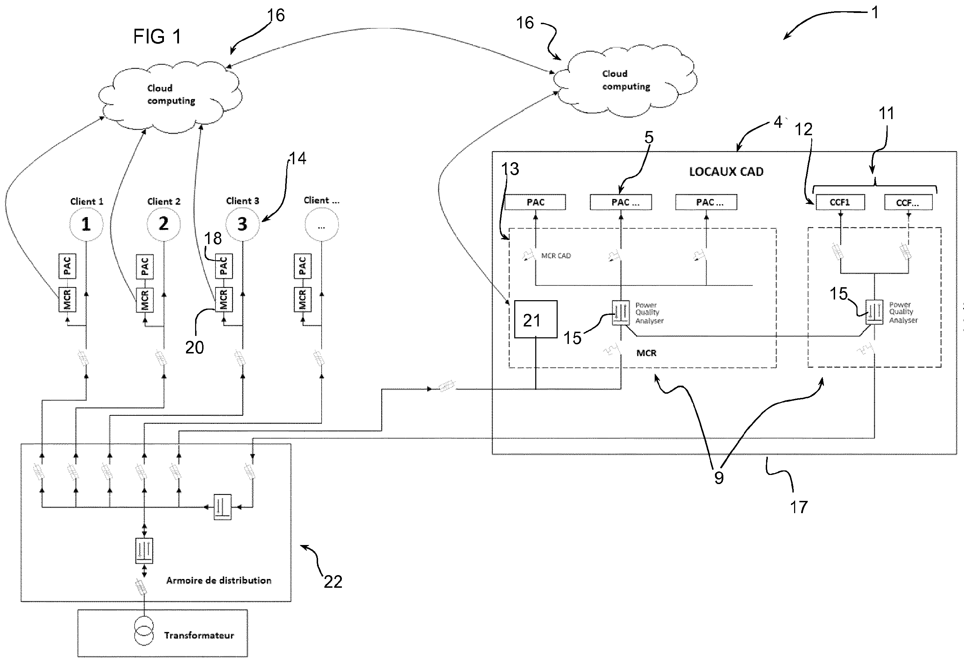

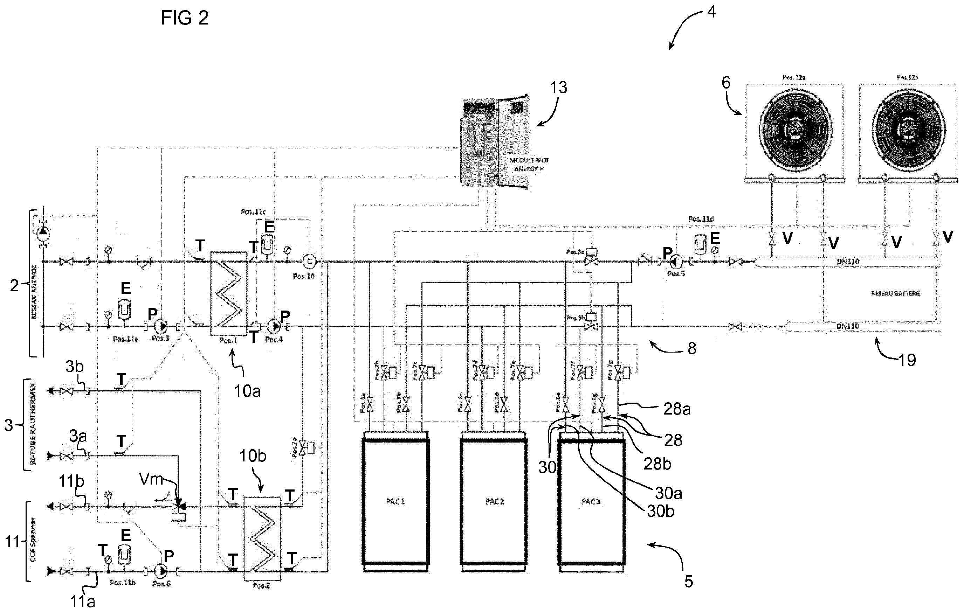

Faisant référence aux figures, commençant par les figures 1 et 2, un système de distribution d'énergie thermique 1 comprend un réseau de distribution à distance d'énergie thermique basse température 2, appelé réseau Anergie, un système d'appoint pour réseau Anergie 4 connectée thermiquement au réseau Anergie 2, et des installations thermiques d'utilisateurs (clients et fournisseurs d'énergie thermique) 14 connectés thermiquement au réseau Anergie 2, notamment à travers des échangeurs de chaleur (non-illustrés).

Le système d'appoint pour réseau Anergie 4 peut en outre être connecté via un échangeur de chaleur 10b à, et/ou comprendre, un système de cogénération d'énergie électrique et thermique, appelé système de couplage chaleur-force (CCF) 11.

Le système d'appoint pour réseau Anergie 4 peut en outre être connecté via un échangeur de chaleur 10b à, et/ou comprendre, un réseau de distribution d'énergie thermique haute température (HT) 3.

Les installations thermiques d'utilisateurs 14 qui sont consommateurs d'énergie thermique, typiquement dans des bâtiments (immeuble résidentiel, maison, usine, centre commercial,...), comprennent typiquement un ou plusieurs réseaux d'eau chaude (non-illustré), une ou plusieurs pompes à chaleur 18, un système MCR 20 connecté électriquement, entre autre, à la pompe à chaleur, des capteurs de température (non-illustré) et des vannes (non-illustré) pour la régulation thermique de l'installation.

Le système d'appoint 4 peut comprendre en outre des analyseurs de puissance 15 des diverses unités génératrices de chaleur ou de froid. Le système d'appoint 4 peut comprendre en outre un module de communication 21 pour la transmission et la reception électronique de données entre le système d'appoint 4 et des installations d'utilisateurs, et/ou des serveurs, via un réseau de communication 16 tel que l'internet. Ces données peuvent servir à la vérification de l'état, le contrôle et la gestion à distance, ou de manière centralisée, du système de distribution d'énergie thermique.

Le réseau Anergie 2 comprend au moins un tube dans lequel circule un fluide caloporteur entre au moins un émetteur de chaleur et une pluralité de consommateurs d'énergie thermique situés à distance de l'émetteur. Le réseau Anergie 2 est typiquement un réseau urbain interconnectant une pluralité de bâtiments d'un quartier résidentiel ou industriel, ou d'un quartier mixte résidentiel et industriel. Le réseau Anergie est en grande partie enterré et peut utiliser le sol pour accumuler de l'énergie thermique, par exemple dû à la production de chaleur solaire en été ou pour un refroidissement de bâtiments, ou pour libérer de l'énergie thermique, par exemple en hiver pour le chauffage des bâtiments ou de l'eau sanitaire. Les réseaux de distribution à distance d'énergie thermique basse température 2 de ce type sont en soi connus et n'ont pas besoin d'être décrit en détail dans la présente.

Le réseau Anergie 2 peut avantageusement être couplé au système d'appoint pour réseau Anergie 4 par un échangeur de chaleur 10a, de sorte à ce que le fluide caloporteur du réseau Anergie est indépendant du fluide caloporteur circulant dans le système d'appoint pour réseau Anergie 4.

Le fluide caloporteur circulant dans le réseau Anergie 2 peut typiquement être de l'eau ou de la saumure. La saumure permet au réseau Anergie de circuler le fluide caloporteur à des températures inférieures à 0°C.

Le système d'appoint pour réseau anergie 4 comprend une ou plusieurs pompes à chaleur 5 un ou plusieurs échangeurs de chaleur air-liquide 6 et un réseau hydraulique 8. Le réseau hydraulique interconnecte les pompes à chaleur 5 au réseau Anergie 2 via un échangeur de chaleur 10a, aux réseaux HT 3 et CCF 11 via un échangeur de chaleur 10b, ainsi qu'aux échangeurs de chaleur air-liquide 6. Le système d'appoint pour réseau Anergie 4 comprend en outre un système de mesure, contrôle et régulation (MCR) 13.

Comme mentionné précédemment, le système de cogénération CCF peut être avantageusement intégré dans le système d'appoint pour réseau anergie 4, de préférence installé dans le même local ou bâtiment que d'autres éléments du système d'appoint, notamment les pompes à chaleur 5. Le système CCF comprend un réseau hydraulique CCF 11 dans lequel circule un fluide caloporteur couplé à travers un échangeur de chaleur à un générateur CCF (non-illustré) produisant de la chaleur et une force mécanique servant à entrainer un générateur électrique (non-illustré) pour la production d'électricité. Le générateur CCF peut notamment être moteur thermique à combustion avec un axe de sortie couplé à un rotor tournant d'un générateur électrique. Le générateur CCF pourrait aussi également être sous forme d'une turbine à gaz ou d'une turbine à vapeur. De tels générateurs CCF sont en soi connus et n'ont pas besoin d'être décrits dans la présente demande. L'installation d'un générateur CCF à proximité des autres éléments du système d'appoint permet de diminuer les pertes et de réduire les coûts liés à l'interconnexion fluidique et électrique du système CCF et les autres éléments du système d'appoint.

Au moins une des pompes à chaleur 5 est une pompe à chaleur liquide-gaz, notamment eau-air, connectée fluidiquement à au moins un échangeur de chaleur air-liquide 6. S'il y a plusieurs pompes à chaleur 5a, 5b...5n, elles peuvent toutes être connectées à des échangeurs de chaleur air-liquide 6, ou certaines peuvent être connectées à une sonde géothermique ou à d'autres sources de chaleur à proximité du lieu d'installation de la pompe à chaleur, telle que des sources de chaleur résiduelle d'une usine. L'échangeur de chaleur air-liquide 6 est installé pour un échange avec l'air environnemental, à savoir l'air extérieur, pour puiser l'énergie renouvelable de l'environnement.

L'échangeur de chaleur air-liquide 6 peut avoir différentes configurations en soi bien connues dans l'état de l'art, comprenant un circuit de fluide caloporteur 26 avec des conduits (p.ex. tubes) ayant une surface d'échange exposée à un flux d'air environnemental. Une partie du circuit couplée à une entrée 26a du circuit est de préférence disposée en aval de la direction du flux d'air par rapport à une partie du circuit connectée à une sortie 26b du circuit fluide caloporteur 26. Cette configuration « croisée » permet d'améliorer l'efficience d'échange de chaleur puisque le gradient de température du flux d'air dans un sens axial à travers l'échangeur de chaleur diminue alors que dans le sens axial opposé la température du fluide caloporteur dans le circuit de fluide caloporteur 26 augmente.

Dans une forme d'exécution préférée, l'échangeur de chaleur air-liquide 6 comprend de préférence un ventilateur 7 qui peut être monté sur le corps ou la structure soutenant les conduits (p.ex. tubes) du circuit de fluide caloporteur 26, pour un flux axial d'air à travers le circuit de fluide caloporteur.

Dans le cadre de l'invention il est toutefois possible d'avoir un flux d'air par d'autres moyens de convection forcée, ou par convection naturelle. Dans ce dernier cas, les tubes seront placés dans un endroit à l'extérieur favorisant un flux d'air à travers l'échangeur. Afin de mieux contrôler l'échange de chaleur il est préférable toutefois d'avoir un ventilateur pour un échange de chaleur par convection forcée à proximité du circuit liquide.

Dans l'invention, il est préférable d'avoir une pluralité d'échangeurs de chaleur, chacun comprenant un circuit de fluide caloporteur et un ventilateur, notamment dans une configuration où chaque échangeur de chaleur 6 est couplé à une pompe à chaleur 5 afin de pouvoir mettre en marche les pompes à chaleur individuellement en fonction du besoin calorifique du système d'appoint 4.

Une pluralité d'échangeurs de chaleur air-liquide 6 peuvent être interconnectées fluidiquement par un réseau batterie hydraulique 19, les circuits 26 étant connectés à la batterie hydraulique à travers des vannes d'arrêt V.

Le réseau hydraulique 8 interconnecte les pompes à chaleur 5 aux divers éléments du système d'appoint comprenant l'échangeur de chaleur air-liquide 6, l'échangeur de chaleur système d'appoint-réseau Anergie 10a, et l'échangeur de chaleur système d'appoint-réseau HT/CCF 10b. Le réseau hydraulique comprend des vannes V1, V2,...Vn pour contrôler le flux de liquide caloporteur dans les diverses sections du réseau hydraulique 8, des pompes P1, P2, ... Pn pour le transport des fluide caloporteur dans diverses sections du réseau hydraulique, et des vases d'expansion E1, E2, ... En pour compenser des variations de pression dans le réseau hydraulique.

Les vannes du réseau hydraulique peuvent comprendre des vannes mélangeuses et des vannes d'arrêt.

Les vannes et les pompes sont arrangées dans le réseau hydraulique 8 de sorte à permettre de raccorder hydrauliquement les pompes à chaleur 5 individuellement avec les échangeurs de chaleur liquide-liquide, notamment du réseau Anergie 10a, et également de pouvoir raccorder hydrauliquement les échangeurs de chaleur air-liquide 6 avec les pompes à chaleur 5, ou directement avec l'échangeur de chaleur système d'appoint-réseau Anergie 10a, selon la température de l'air extérieur et les besoins calorifiques du système d'appoint qui dépend notamment de la température du circuit caloporteur circulant dans le réseau Anergie 2. La connexion directe des échangeurs de chaleur air-liquide 6 avec le réseau Anergie 2 permet d'optimiser le coefficient de performance (Coefficient Of Performance COP) du système d'appoint et par conséquent aussi du système de distribution d'énergie thermique 1 dans sa globalité.

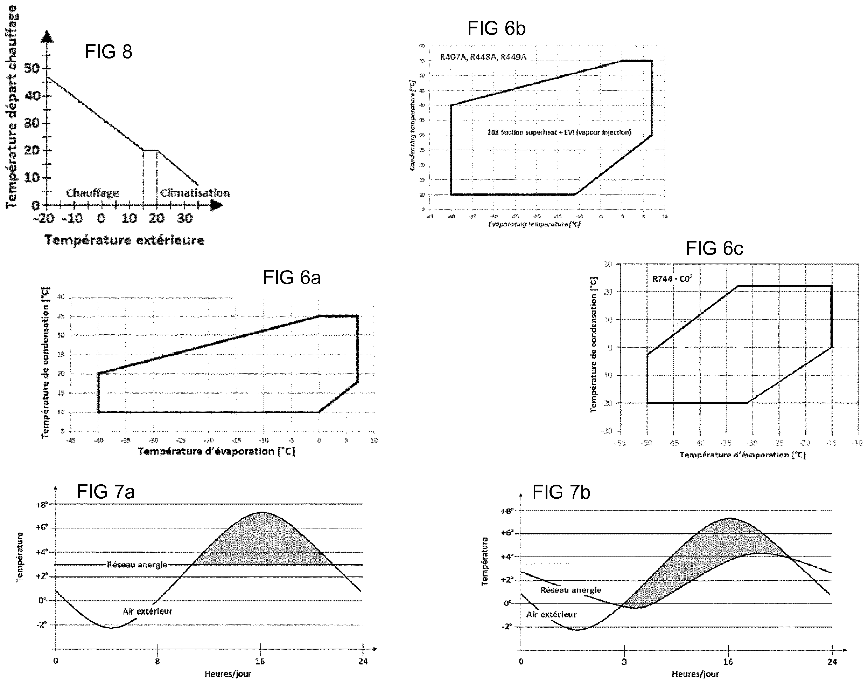

Le fait de pouvoir coupler fluidiquement les échangeurs de chaleur air-liquide 6 directement au réseau Anergie 2 lorsque la température de l'air extérieur est supérieure à la température du réseau Anergie 2 tel que illustré dans les parties grises des figures 7a et 7b, plutôt que de coupler les échangeurs air-eau 6 aux pompes à chaleur 5, permet d'avoir une efficience optimale. En effet, dans les systèmes conventionnels, les pompes à chaleur air-eau sont utilisées, mais l'efficience est inférieure au couplage direct des échangeurs de chaleur air-eau avec le réseau Anergie lorsque les températures de l'air extérieur sont supérieures aux températures du réseau Anergie.

Les pompes à chaleur sont nécessaires afin de transférer de la chaleur au réseau Anergie lorsque la température de l'air extérieur est inférieur au température du réseau Anergie, mais en pouvant découpler les échangeurs air - liquide 6 des pompes à chaleur 5 correspondant pour une connexion hydraulique directe avec l'échangeur de chaleur 10a couplé au réseau Anergie 2, le rendement est augmenté du fait qu'il n'y a que la consommation électrique des ventilateurs (s'il y en a), sans la consommation électrique des compresseurs des pompes à chaleur 5. Aussi, le fait que les échangeurs de chaleur air-liquide 6, lorsqu'il y a une pluralité, sont découplés des pompes à chaleur 5, permet de les utiliser en parallèle pour alimenter une pompe à chaleur ou plusieurs pompes à chaleur à choix, ou directement le réseau Anergie, avec un maximum de flexibilité permettant d'optimiser le COP.

Les pompes à chaleur 5 comprennent un circuit évaporateur 28 et un circuit condenseur 30. Le circuit évaporateur est la partie basse pression de la pompe à chaleur et le circuit condenseur est la partie haute pression de la pompe à chaleur. Le circuit évaporateur comprend une entrée 28a et une sortie 28b, connectés au réseau Anergie 2 via échangeur de chaleur 10a, ainsi qu'au réseau HT 3 et au réseau CCF 11. Le circuit condenseur 30 comprend une entrée 30a et une sortie 30b, connectés au réseau hydraulique 8.

Le fluide caloporteur circulant dans l'échangeur de chaleur 10a du côté du système d'appoint 4, et qui circule aussi dans un circuit évaporateur 28 de la pompe à chaleur 5 et dans le réseau HT 3 et/ou CCF 11, doit pouvoir supporter des températures inférieures à 0°C et supérieures à la température du réseau HT 3 et/ou CCF 11, notamment dans une gamme de températures allant typiquement de -20°C à 90°C. Ce fluide peut par exemple être de l'eau glycolée, bien connu dans les systèmes thermiques.

Le réseau de distribution d'énergie thermique haute température 3 comprend au moins deux tubes 3a, 3b dans lequel circule, en circuit fermé, un fluide caloporteur entre l'échangeur de chaleur 10b et une source de chaleur haute température (HT), telle qu'un générateur thermique photovoltaïque, solaire, ou à combustible. La source de chaleur HT peut être une source de chaleur local, à savoir une source d'énergie généré dans le bâtiment dans lequel se trouve les pompes à chaleur 5 du système d'appoint 4, ou une source de chaleur à distance, par exemple résultant d'une opération industrielle, telle qu'une usine de transformation de matériaux, ou d'un central de production d'énergie. Dans ce dernier cas, le circuit fermé du réseau HT connecté au système d'appoint 4, peut être couplé à la source de chaleur produit à distance par un échangeur de chaleur à proximité de la source de chaleur, de sorte à ce qu'une partie du circuit fermé du réseau HT 3 soit disposé localement (dans le système d'appoint 4).

Le réseau de distribution CCF 11 comprend au moins deux tubes 11a, 11b dans lequel circule, en circuit fermé, un fluide caloporteur entre l'échangeur de chaleur 10b et un générateur CCF, tel qu'un moteur thermique (p. ex. moteur à combustion). Le générateur CCF est de préférence installé localement, à savoir à proximité des pompes à chaleur 5, par exemple dans le même local ou bâtiment.

L'échangeur de chaleur 10b du réseau CCF 11 et/ou du réseau HT 3 peut être connecté par des vannes du réseau hydraulique 8 soit à un ou plusieurs pompes à chaleur 5, soit directement à l'échangeur de chaleur 10a du réseau Anergie afin de pouvoir avoir un échange de chaleur directement entre le réseau HT 3 et/ou le réseau CCF 11 avec le réseau Anergie en fonction des besoins toute en optimisant le COP du système de distribution d'énergie thermique 1.

Le tube d'entrée 3a de fluide du réseau HT 3, peut avantageusement être connecté fluidiquement à travers une vanne mélangeuse Vm au tube de sortie 11b du réseau CCF afin d'utiliser le générateur CCF (non-illustré) pour augmenter la température du fluide caloporteur provenant du réseau HT. La température de l'échangeur de chaleur du côté du générateur CCF étant généralement plus élevée que la température du réseau HT, il y a un avantage pour améliorer le COP globale de faire circuler le fluide caloporteur du réseau HT en série à travers le réseau CCF lorsque ce dernier est en marche, plutôt que de mélanger les fluides caloporteurs traversant l'échangeur de chaleur 10b ou de connecter individuellement les réseaux HT 3 et CCF 11 par des échangeurs de chaleur séparés au réseau hydraulique 8 du système d'appoint 4. Par ailleurs cela permet de diminuer les équipements (notamment le nombre d'échangeurs de chaleur) pour des gains en place et en diminution des coûts de maintenance et d'installation.

Le système MCR 13 est de préférence installé dans le bâtiment dans lequel les pompes à chaleur 5 du système d'appoint 4 sont installés, et est connecté à divers sondes de température T (y compris une sonde extérieure), pompes P, vannes V, et unités d'entrainement (moteurs) des compresseurs des pompes à chaleur 5 et des ventilateurs 6, pour la régulation de la température et du flux de fluide caloporteur dans le réseau hydraulique 8 en fonction des besoins.

Le système d'appoint selon l'invention à donc une configuration modulaire pouvant être adapté en fonction des besoins, par exemple il est possible de raccorder plusieurs pompes à chaleur 5 en parallèle, et dans ce cas de figure des vannes d'arrêt commandées par le module MCR 13 permettent d'isoler hydrauliquement les unités qui ne sont pas en fonction. De cette façon on préserve une efficience maximale.

Dans un exemple d'installation pratique pour un quartier résidentielle de quelques centaines habitants, le dimensionnement d'un échangeur de chaleur air-liquide 6 aura par exemple un débit d'air maximale de 5000m3/h avec un différentiel de température d'air de 4° et d'un différentiel de température du fluide caloporteur de 3°C et une perte de charge d'une valeur de maximale 30kPa. Le dimensionnement thermique global des échangeurs air-eau devra satisfaire la puissance frigorifique maximale atteinte lorsque les besoins de chauffage seront les plus importants. Le raccordement hydraulique sur les échangeurs de chaleur air-liquide 6 de type contre-courant comme mentionné précédemment, permet d'atteindre une température du fluide caloporteur à la sortie de l'échangeur la plus proche possible de la température du flux d'air entrant dans le dit échangeur de chaleur.

Le choix du fluide frigorigène des pompes à chaleur 5 devra être fait pour un facteur GWP (Global Warming Potential) le plus faible possible avec l'enveloppe de fonctionnement en adéquation avec la température minimale de l'air extérieure du lieu géographique d'installation du réseau anergie 2 et avec une température de référence du réseau qui correspond à la température moyenne du lieu à la profondeur dans le sol du tube du réseau anergie 2, par exemple à 1,5 mètres de profondeur.

La température d'évaporation minimale sera égale à la température minimale de fonctionnement de la partie froide de la batterie hydraulique 19 et à ce point de fonctionnement la température de condensation sera égale ou légèrement supérieure. La température d'évaporation maximale sera égale ou supérieure à 0°C avec une température de condensation la plus faible possible. L'enveloppe idéal du compresseur devrait correspondre à l'enveloppe de fonctionnement de la figure 6a. Toutefois des fluides frigorigènes pouvant fonctionner avec une température d'évaporation de 0°C avec une température de condensation de 10°C sont ne sont pas courantes et pour palier à ce problème il est possible d'utiliser des compresseurs pour la réfrigération permettant une plage de fonctionnement apte à réchauffer le réseau anergie avec une bonne efficience. Par exemple un fluide frigorigène avantageux à utiliser est le type R449, avec un GWP de 1300 et un ODP (Ozone Depletion Potential) de 0 (figure 6b).

Dans le future un fluide frigorigène naturel de type C02 pourra être envisagé car celui-ci a idéalement un GWP de 0 et un ODP (Ozone Depletion Potential) de 0. Sa température critique étant de 31°C donc largement supérieur au 10°C souhaité. Un fonctionnement au mode sous-critique est bien adapté. La figure 6c illustre l'enveloppe de fonctionnement pour ce type de frigorigène.

Les fluides caloporteurs dans les différentes parties du systèmes séparées par des échangeurs de chaleur peuvent avoir des compositions différentes, typiquement des mélanges antigel, optimisées pour la plage de température de fonctionnement dans la partie concerné et des propriétés de viscosité. Dans le circuit hydraulique des pompes à chaleur et des batteries hydrauliques froides 19, le mélange peut par exemple être principalement de type éthylène-glycol avec une protection antigel supérieure à la plus basse température extérieure atteinte dans le lieu géographique de l'installation. Le choix de ce mélange est principalement dicté par le souci d'obtenir une bonne fluidité à très basse température. Par exemple des températures minimales peuvent être de -30°C en région de montagne, -25°C en région de plaine, et -20°C dans des villes. Cette différentiation est très importante pour augmenter l'efficience globale de l'installation en fonction de la température moyenne annuel de fonctionnement.

Dans le circuit CCF le fluide caloporteur peut également comprendre un mélange antigel, par exemple composé de propylène glycol qui est non toxique pour une protection à -5°C dans tous les cas de figure.

Dans le circuit du réseau anergie, le fluide caloporteur peut être de l'eau avec un mélange propylène glycol avec une protection à -5°C, ou une saumure.
L'échangeur de chaleur 10a entre le réseau anergie et les pompes à chaleur 5 peut par comprendre des plaques avec un dimensionnement permettant d'obtenir des puissances de transfert élevées avec un différentiel de température faible de 3-5°C.
Les vannes de sélection des différentes pompes à chaleur 5 devront pouvoir fonctionner avec la température minimale de l'installation qui est par exemple entre -30°C et -20°C. Pour des zones très froides les vannes peuvent avoir un axe d'entrainement chauffé et être en un matériau résistant au froid telle qu'en ABS (Acrylnitril-Butadien-Styrol).

Le système comprend plusieurs modes de fonctionnement selon les besoins, le contrôle et la régulation des éléments étant effectués par le module électronique de gestion MCR 13.
La priorité du module MCR 13 est d'assurer que la température du fluide caloporteur circulant dans le réseau anergie 2 soit à une température adéquate pour le bon fonctionnement des pompes à chaleur des utilisateurs 14 qui sont raccordées sur le réseau anergie 2. La température de retour du réseau anergie 2 devra être maintenue à une température supérieure à 0°C pour éviter le gel du terrain enveloppant le tube du réseau anergie. Dans certains cas de figure le fluide caloporteur peut descendre à une température inférieure à 0°C pendant un court laps de temps, par exemple de quelques heures.
En fonction de la température du réseau anergie 2, le module MCR 13 fait varier la puissance produite par les pompes à chaleur 5 du système d'appoint. La température moyenne du retour du réseau anergie 2 sera toujours maintenue au-dessus de 0°C. Un premier capteur de température T1 dans le réseau anergie 2, à l'entrée de l'échangeur de chaleur 10a est connecté au module MCR 13 et donne l'information de la température du réseau anergie 2. Ce premier capteur de température donne la consigne pour que le module MCR 13 enclenche, déclenche et régule les différents éléments (vannes, pompes, ventilateurs) pour chercher à obtenir la meilleure efficience possible en fonction de la température du réseau anergie 2 et la température de l'air extérieur. Un deuxième capteur de température T2 connecté au module MCR 13 peut être monté dans le réseau anergie 2 à la sortie de l'échangeur de chaleur 10a.

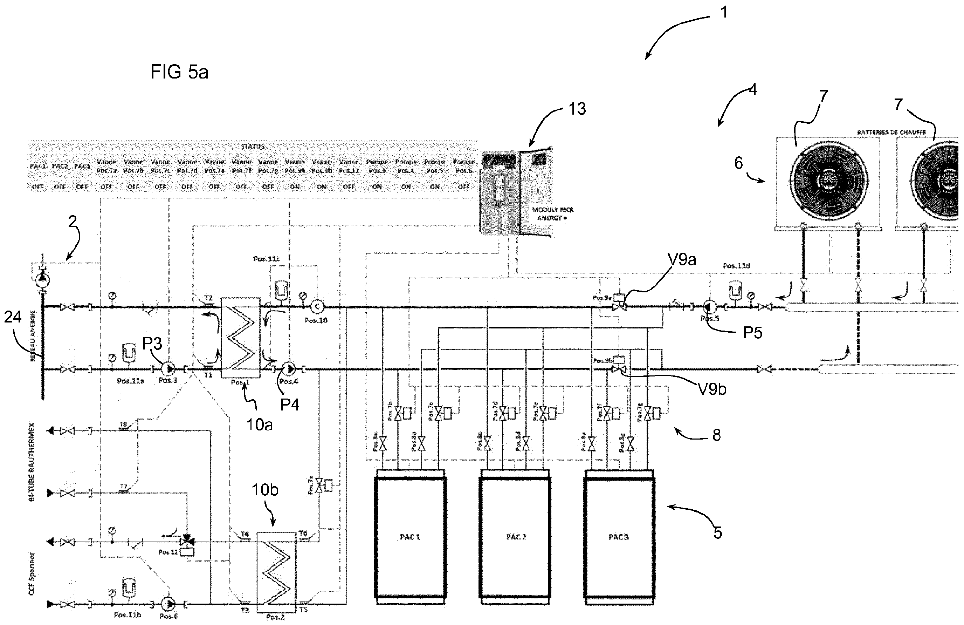

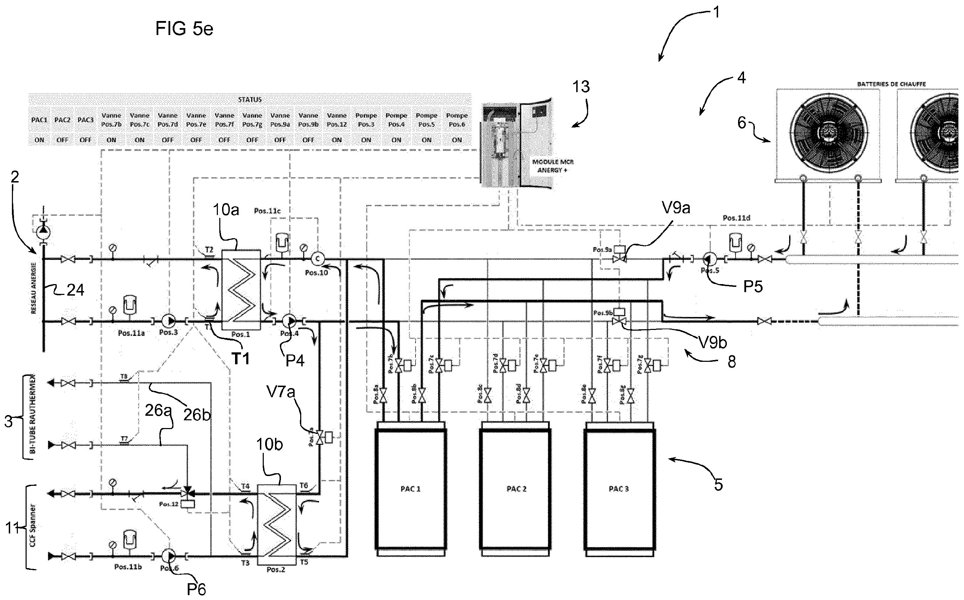

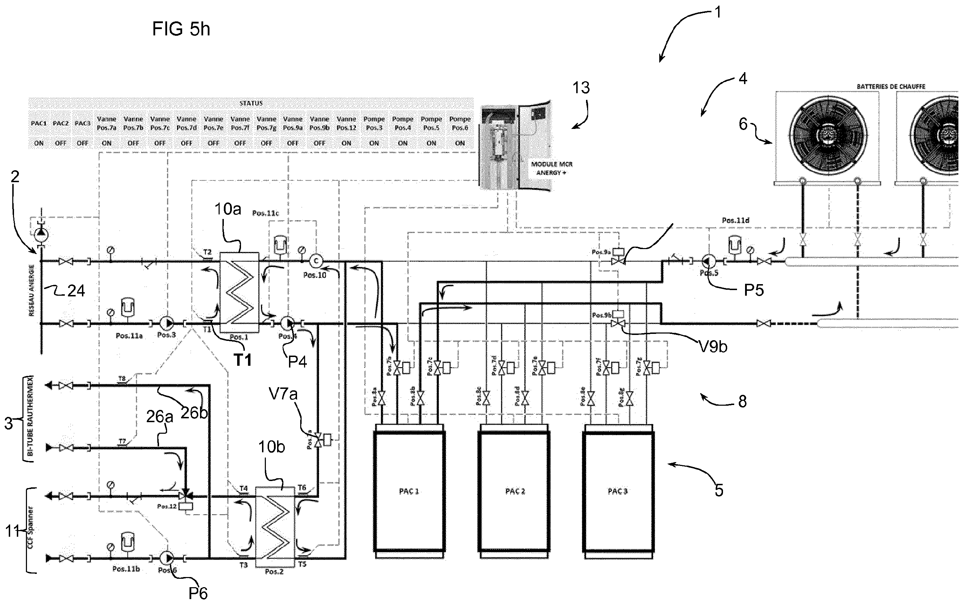

Dans un premier exemple de cas de figure de fonctionnement illustré à la figure 5a, la température de l'air extérieur, mesuré par un capteur de température (non-illustré) connecté au MCR 13, est supérieure à la température mesuré par le capteur de température T2 du fluide caloporteur qui circule dans le tube du réseau anergie 2. Cela correspond aux zones grises indiquées dans les figures 7a, 7b illustrant des exemples de mesures de température du réseau anergie et de l'air extérieur sur une journée. Le module MCR 13 commande l'ouverture des vannes deux voies V9a et V9b et actionne des pompes de circulation P4, P5 dans le réseau hydraulique 8 du système d'appoint 4. Le module MCR commande aussi l'actionnement des ventilateurs 7 des échangeurs de chaleur air-liquide 6. Le module MCR 13 commande aussi l'actionnement d'une pompe P3 couplé au réseau anergie 2 faisant circuler le fluide caloporteur du réseau anergie dans l'échangeur de chaleur 10a à l'interface avec le réseau hydraulique 8 du système d'appoint. Comme la température du fluide caloporteur du réseau anergie 2 est plus froide que la température de l'air extérieure, ce dernier va réchauffer le fluide du réseau anergie à travers l'échangeur de chaleur réseau anergie-système d'appoint 10a. Le système MCR 9 peut comprendre un compteur d'énergie chaleur C10 dans le réseau hydraulique 8 du système d'appoint, notamment à l'entrée de l'échangeur de chaleur 10a, qui permet de mesurer la quantité d'énergie thermique transitant dans le réseau. Le module MCR 13 via cette mesure d'énergie mesure peut réguler la vitesse des pompes P4, P5 et la vitesse de rotation des ventilateurs 7 des échangeurs air-liquide 6 pour obtenir le meilleur rendement possible en mesurant la consommation électrique. Le but est de transférer de l'énergie thermique avec les plus bas coûts. Les pompes à chaleur 5 peuvent avantageusement être arrêtées pour autant que la température de retour du réseau anergie mesuré par le capteur de température T2 est supérieure à 0°C.

Quand la température de retour du fluide caloporteur circulant dans le réseau anergie 2 mesuré par le capteur de température T2 est en-dessous ou proche de 0°C et que le mode de fonctionnement décrit dans le premier exemple, c'est-à-dire uniquement en utilisant les échangeurs de chaleur air-liquide 6 directement couplés à l'échangeur de chaleur 10a entre le système d'appoint et le réseau anergie 2, est insuffisant pour contenir la baisse de température du fluide caloporteur, le module MCR 13 commande un apport d'énergie d'autres sources d'énergie du système d'appoint. Ces autres sources d'énergie peuvent comprendre une ou plusieurs des pompes à chaleurs 5, le réseau HT 3, et/ou le système CCF 11.

Dans un deuxième exemple, quand la température de retour du fluide caloporteur circulant dans le réseau anergie 2 est en-dessous ou proche de 0°C et le mode de fonctionnement en utilisant les échangeurs de chaleur air-liquide 6 directement est insuffisant, le système MCR commande l'enclenchement d'une ou plusieurs des pompes à chaleur 5 en fonction du besoin en énergie. De préférence, les pompes à chaleur sont enclenchées progressivement et successivement en fonction du besoin énergétique, et par conséquent le nombre de pompes en chaleur enclenchés dépendra de la demande énergétique. Pour une demande donnée, l'utilisation d'une partie des pompes à chaleur est plus efficiente que de faire marcher toutes les pompes à chaleur simultanément mais à régime plus faible.

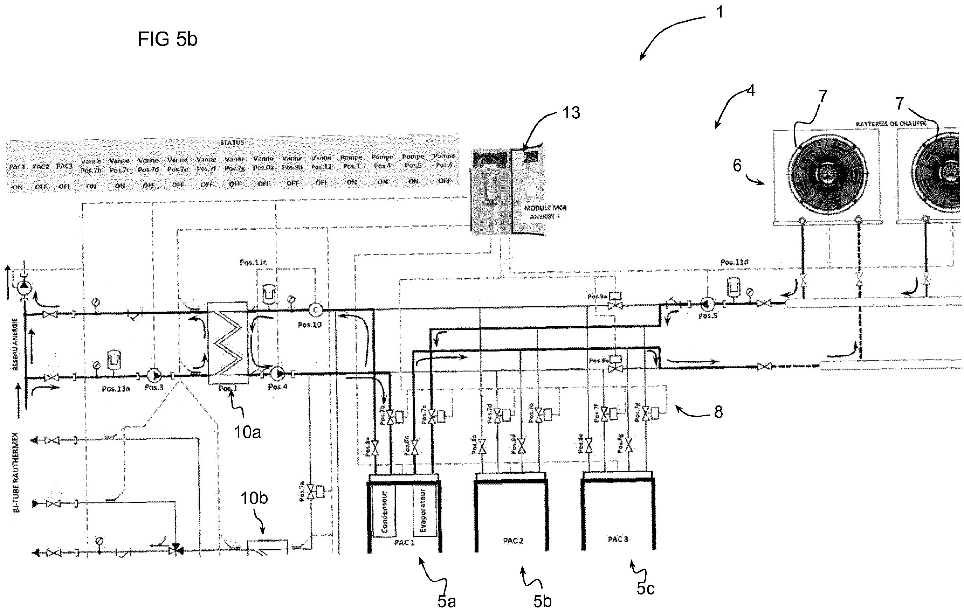

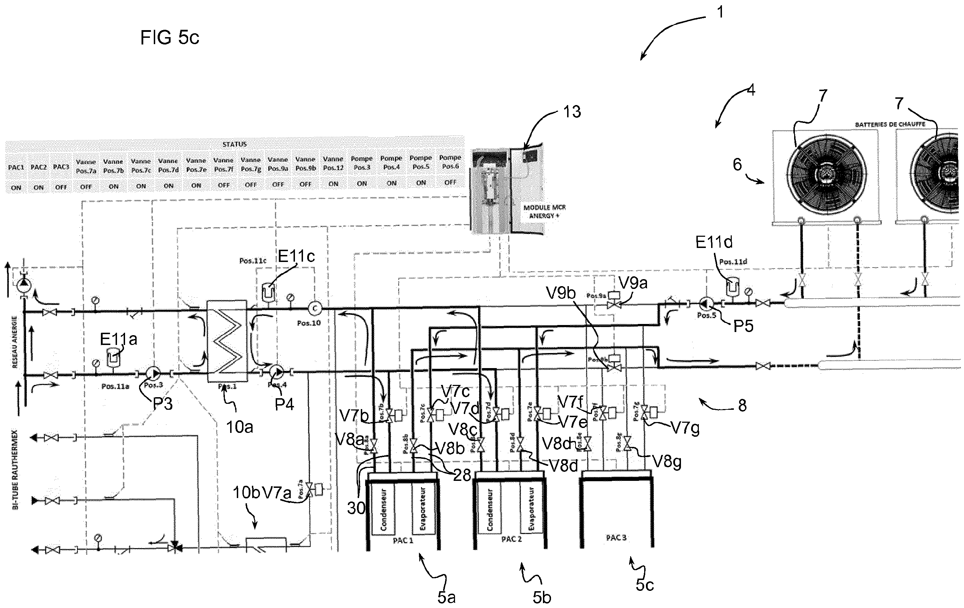

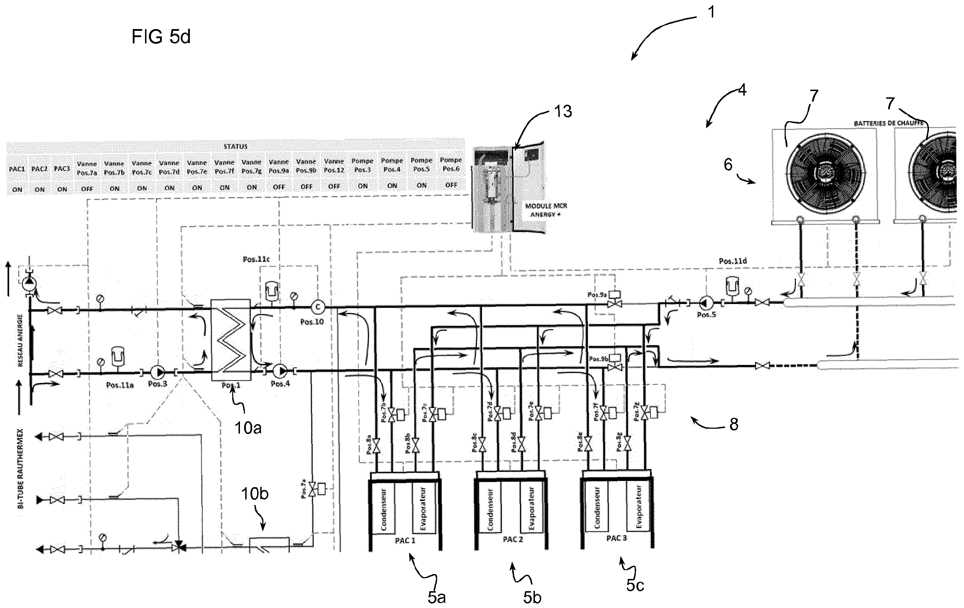

Les pompes à chaleur sont reliées hydrauliquement en parallèles, et en agissant sur les différentes vannes V7b à V7g, V8a à V8g, l'ouverture et la fermeture des circuits condenseurs 30 et évaporateurs 28 de chaque pompe à chaleur 5 peuvent être contrôlées par le système MCR 13 pour relier les pompes à chaleur 5 au réseau hydraulique 8 du système d'appoint 4. En cas de besoin énergétique, dans un premiers temps, une première pompe à chaleur 5a est enclenchée tel que illustré à la fig. 5b et la chaleur produite est transférée au réseau anergie 2 l'échangeur de chaleur 10a. Le module MCR 13 recevant une mesure de la température du réseau anergie 2 par le capteur de température T1 peut effectuer un calcul afin de simuler la variation de la température à court terme (p.ex. 1 à 15 minutes). Si la simulation indique que la température continue de descendre, une deuxième pompe à chaleur 5b peut être enclenchée en parallèle tel qu'illustré à la fig. 5c. La deuxième pompe à chaleur 5b peut avoir la même puissance que la première pompe à chaleur 5a. Si la tendance de température du réseau anergie 2 est toujours à la baisse, une troisième pompe à chaleur 5b peut être enclenchée en parallèle tel qu'illustré à la fig. 5d.

Dans le cadre de l'invention, le système d'appoint 4 peut n'avoir qu'une pompe à chaleur, ou que deux pompes à chaleur, ou de plus de trois pompes à chaleur, selon les besoins énergétiques à prévoir, qui dépendent entre autre du lieu géographique et du nombre d'utilisateurs.

Quand toutes les pompes à chaleur 5 sont utilisées, si la température du réseau anergie est toujours à la baisse, le module MCR 13 peut commander une augmentation de la puissance thermique des pompes à chaleur 5 si elles ne marchent pas à leur puissance maximale. Les pompes de circulation P4, P5 et la vitesse des ventilateurs 7 peut être choisie pour obtenir un différentiel de température fixe, par exemple d'environ 3°C, entre entrées et sorties des condenseurs 30, et/ou entre entrées et sorties des évaporateurs 28, et/ou entre entrées et sorties 26a, 26b des échangeurs de chaleur air-liquide 6.

La modulation de puissance des pompes à chaleur 5 peut être choisie pour augmenter la température du fluide caloporteur du réseau anergie 2 à une température de consigne d'environ 4°C à 6°C, par exemple 5°C. Cette température permet avantageusement de limiter le transfert d'énergie au terrain qui enveloppe le tube (conduit) du réseau anergie 2.

Si la température du fluide caloporteur du réseau anergie est en augmentation et dépasse une valeur seuil, par exemple la valeur de consigne ou la valeur de consigne plus une marge, par exemple de 1°C de plus que la valeur de consigne, le MCR 13 commande une diminution de la puissance des pompes à chaleur 5. La diminution de la puissance peut être effectuée dans l'ordre inverse de l'augmentation de puissance décrit ci-dessus, en réduisant le nombre de pompes en chaleur en marche.

La possibilité de mettre en marche les pompes à chaleur successivement en parallèle ou de les découpler en laissant les échangeurs de chaleur air-eau pour chauffer directement le réseau anergie à travers l'échangeur de chaleur 10b permet d'optimiser le COP moyen de l'ensemble du système d'appoint 4 en tenant de la consommation de toutes les pompes et compresseurs nécessaire au fonctionnement des pompes à chaleur et de la circulation de fluide caloporteur dans le réseau hydraulique et les échangeurs de chaleur air-liquide du système d'appoint.

Quand l'apport de chaleur au réseau anergie 2 par toutes les pompes à chaleur 5 associés aux échangeurs de chaleur air-eau 6 est insuffisant, de l'énergie calorifique peut être apporté par le réseau CCF 11 d'un système CCF (couplage chaleur-force). De l'énergie calorique peut aussi être apporté par le réseau HT 3. Le système CCF 11 peut être enclenché si les pompes à chaleur et le réseau HT 3 (si disponible) ne suffisent pas pour atteindre la température voulue du réseau anergie 2.
Par ailleurs, lorsque la température de l'air extérieure est très basse, la consommation électrique des pompes à chaleur 5 devient plus important et l'utilisation d'un appoint thermique tel qu'un système de couplage chaleur-force peut optimiser le COP global.

La chaleur du réseau CCF 11 est transférée par l'intermédiaire de l'échangeur de chaleur 10b au réseau hydraulique 8 par l'ouverture de la vanne V7a et ensuite au réseau anergie 2 par l'échangeur de chaleur 10a.

Le module MCR 13 contrôle l'ajustement de la vitesse de la pompe de circulation P4 pour assurer un différentiel de température voulue, par exemple de 2 à 4 °C, p.ex. 3°C, sur le condenseur 30 de la pompe à chaleur 5 ou des pompes à chaleur 5. La pompe P6 du circuit hydraulique du réseau CCF 11 est également ajustée pour garantir le transfert d'énergie à travers l'échangeur de chaleur 10b en fonction de la température du fluide caloporteur du réseau CCF 11. En fonction des besoins et de l'apport en énergie du système CCF, le nombre de pompes à chaleur 5 enclenchées peut être ajusté de zéro à toutes

La part électrique produite par le générateur CCF peut être en partie utilisée directement par la ou les pompes à chaleur 5 qui sont enclenchées. Tous les accessoires qui constituent l'e système d'appoint peuvent aussi utiliser l'énergie électrique générée. Le solde de production électrique peut être distribué aux installations électriques des utilisateurs 14 du réseau anergie 2, qui peuvent être raccordées par une armoire de distribution 22 sur le même transformateur d'alimentation comme illustré à la figure 1.

Le module MCR du CAD étant relié à l'analyser électrique qui alimente le groupe CCF, il est parfaitement possible de multiplier le nombre d'unités de couplage chaleur ainsi que le nombre de pompes à chaleur pouvant autoconsommer l'électricité produite par toutes les unités CCF.

Quand la température de l'air extérieur est inférieure à 3-4 degrés, la température du fluide caloporteur circulant dans les échangeurs de chaleur air-liquide 6 sera inférieur à -1°C et dans ce cas de figure l'humidité contenu dans l'air extérieur va condenser sur la surface extérieure (p.ex. des ailettes) de l'échangeur de chaleur et comme la température de la surface est inférieur à 0°C, cette eau de condensation va givrer. La formation de givre diminue l'efficience de l'échange thermique. Dans un troisième exemple, pour éliminer une couche de givre sur les échangeurs de chaleur air-liquide 6, dans une forme d'exécution avantageuse, le réseau anergie qui est à une température supérieure à 0°C peut être couplé au fluide caloporteur du réseau hydraulique 8 comme illustré dans la figure 5a (mais dans ce cas les ventilateurs ne sont pas en marche), pour réchauffer le fluide caloporteur de la partie du circuit qui alimente les échangeurs air-liquide 6.

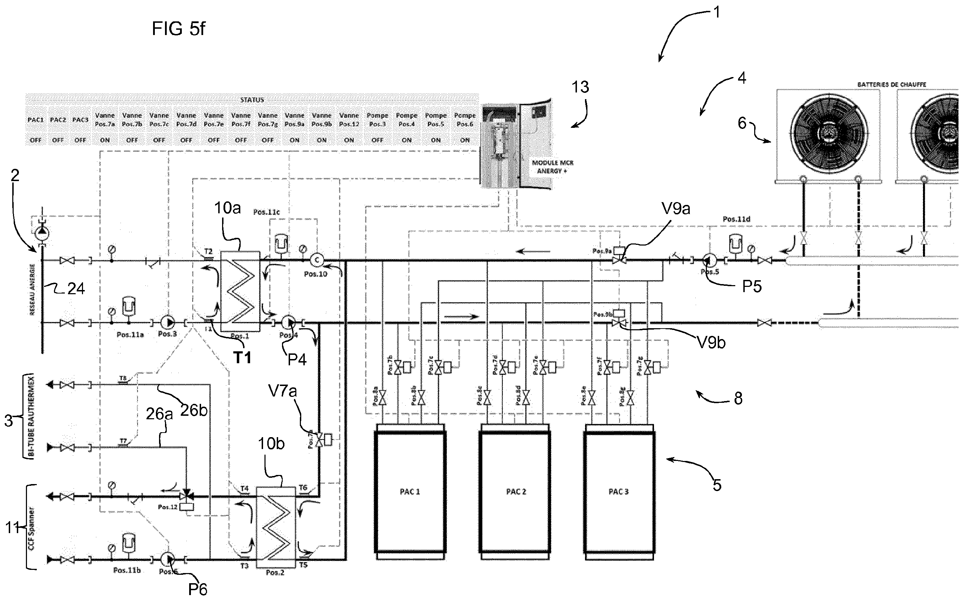

Dans le cas de figure où le système CCF est en fonction, il est avantageux d'utiliser la chaleur de ce système, comme illustré dans la figure 5f, car celle-ci est à plus haute température que celle du réseau anergie avec la conséquence d'une rapidité accrue du cycle de dégivrage.

Si le système CCF 11 se trouve directement dans un bâtiment qui demande du chauffage et de l'eau chaude sanitaire, il est possible de dériver avec la vanne V12 une partie de la production pour alimenter un réseau HT 3, comme illustré dans la figure 5f, le réseau HT 3 étant dans ce cas relié à la distribution d'eau de chauffage et de l'eau chaude sanitaire du bâtiment.

La régulation dynamique et auto-adaptative du module MCR 13 en fonction de la température de l'air extérieur permet de maximiser le nombre d'heures de fonctionnement du système d'appoint 4 sans l'intervention des pompes à chaleur 5, ou avec un minimum des pompes à chaleur nécessaires, qui ont un coefficient de performance plus faible que l'usage des échangeurs de chaleur air-eau 6 avec ventilateurs 7.

Le module MCR 13 via le compteur de chaleur C10, peut comptabiliser la production thermique quotidienne injectée dans le réseau anergie 2. Le rapport de la variation de température du fluide caloporteur et de l'énergie injecté permet d'une façon simple de déterminer si les pompes à chaleur 5 et/ou le système CCF 11 doivent être utilisés, le but étant de maximiser le fonctionnement du système d'appoint sans le système CCF 11 et sans ou avec un minimum des pompes à chaleur 5 dans la période où la température extérieure est supérieure à la température du fluide caloporteur du réseau anergie 2 comme illustré dans les figures 7a et 7b..

### Liste des références

Système de distribution d'énergie thermique 1
   **Réseau de distribution (à distance) d'énergie thermique basse température 2**
      **(réseau Anergie)**
      monotube 24
   **Réseau de distribution d'énergie thermique haute température 3**
      **(réseau HT)**
      tubes 26a, 26b
   **Système d'appoint pour réseau Anergie 4**
      **Pompes à chaleur (PAC) 5, 5a, 5b, ...5n**
         circuit évaporateur 28
            entrée 28a
            sortie 28b
         circuit condenseur 30
            entrée 30a
            sortie 30b
      **Echangeur de chaleur air environnemental (extérieur) - liquide (eau) 6 , 6a, 6b ...6n** (Echangeur air-liquide)
         **Circuit fluide caloporteur 26**
            entrée 26a
            sortie 26b
         **Ventilateur 7**
         **Réseau d'interconnexion de batterie hydraulique 19**
      **Réseau hydraulique 8**
         **Vannes V1, V2, V3, V4, V5, V6....Vn**
            vannes mélangeuses
            vannes d'arret
         **Pompes P1, P2... Pn**
         **Vases d'expansion E1, E2...En**
      **Système de Mesure, Contrôle, et Régulation (système MCR) 9**
         **Module de commande (module MCR) 13**
         **Capteurs**
            capteurs de temperature **T, T1, T2...Tn**
            capteurs de flux (débit)
         **compteur de puissance C, C10**
         **Module de communication 21**
         **Analyseur (Power Quality Analyser) 15**
      **Echangeurs de chaleur liquide-liquide 10**
         échangeur de chaleur système d'appoint / réseau anergie 10a
         échangeur de chaleur système d'appoint / réseau HT 10b
         échangeur de chaleur système d'appoint / réseau CCF 10c
      **Système de cogénération (système de couplage chaleur-force (CCF)) 11**
         **Réseau CCF 11**
         **Générateur CCF 12**
      **local (bâtiment) 17**
   **Installations thermiques d'utilisateurs (notamment de bâtiments) 14**
      **Pompe à chaleur 18**
      **Système MCR 20**
      Réseau de chauffage / refroidissement bâtiment
      Réseau d'eau chaude sanitaire (réseau ECS)
   Réseau ou armoire de distribution électrique 22
   **Réseau de communication 16**

## Revendications

1. Système d'appoint (4) pour un réseau de distribution à distance d'énergie thermique basse température (réseau anergie) (2) connectée à des installations thermiques d'utilisateurs, comprenant une ou plusieurs pompes à chaleur (5) couplé thermiquement au réseau anergie via un échangeur de chaleur (10a), un ou plusieurs échangeurs de chaleur air-liquide (6) couplé thermiquement à l'air extérieure, et un réseau hydraulique (8) interconnectant les pompes à chaleur (5) à l'échangeur de chaleur (10a) du réseau anergie (2), au moins une des pompes à chaleur étant une pompe à chaleur liquide-air connectée fluidiquement par le réseau hydraulique (8) à au moins un desdites échangeurs de chaleur air-liquide (6), le système d'appoint comprenant en outre un système de mesure, contrôle et régulation (MCR) (13), **caractérisé en ce que** le réseau hydraulique comprend des vannes commandées par le système MCR (13) et un circuit hydraulique configurés pour permettre une connexion directe des desdites échangeurs de chaleur air-liquide (6) à l'échangeur de chaleur (10a) du réseau anergie (2).

2. Système d'appoint selon la revendication précédente **caractérisé en ce qu'**il comprend en outre un système de cogénération d'énergie électrique et thermique (système CCF) (11) couplé thermiquement au réseau hydraulique (8) via un échangeur de chaleur (10b).

3. Système d'appoint selon la revendication précédente **caractérisé en ce que** le réseau hydraulique comprend des vannes commandées par le système MCR (13) et un circuit hydraulique configurés pour permettre une connexion directe du système CCF à l'échangeur de chaleur (10a) du réseau anergie (2).

4. Système d'appoint selon l'une des revendications précédentes **caractérisé en ce qu'**il comprend en outre un réseau de distribution d'énergie thermique haute température (réseau HT) (3) couplé thermiquement au réseau hydraulique (8) via un échangeur de chaleur (10b).

5. Système d'appoint selon la revendication précédente **caractérisé en ce que** le réseau hydraulique comprend des vannes commandées par le système MCR (13) et un circuit hydraulique configurés pour permettre une connexion directe du réseau HT (3) à l'échangeur de chaleur (10a) du réseau anergie (2).

6. Système d'appoint selon l'une des revendications précédentes **caractérisé en ce qu'**il comprend une pluralité desdites pompes à chaleur (5).

7. Système d'appoint selon la revendication précédente **caractérisé en ce que** les pompes à chaleur sont interconnectées fluidiquement au réseau hydraulique (8) en parallèle, chaque pompe à chaleur étant connectée au réseau hydraulique (8) à travers des vannes commandées individuellement par le système MCR (13) de façon à permettre l'enclenchement individuel de chaque pompe à chaleur indépendamment des autres pompes à chaleur.

8. Système d'appoint selon l'une des revendications précédentes **caractérisé en ce que** les échangeurs de chaleur air-liquide (6) comprennent des ventilateurs (7) commandées par le système MCR (13).

9. Système d'appoint selon l'une des revendications précédentes **caractérisé en ce qu'**il comprend une pluralité desdites échangeurs de chaleur air-liquide (6).

10. Système d'appoint selon la revendication précédente **caractérisé en ce que** les échangeurs de chaleur air-liquide (6) sont interconnectées fluidiquement au réseau hydraulique (8) en parallèle.

11. Système d'appoint selon l'une des revendications précédentes **caractérisé en ce que** le système MCR comprend une pluralité de capteurs de température, incluant au moins un capteur de température (T1) fournissant une mesure de température du fluide caloporteur dans le réseau anergie (2) et au moins un capteur de température fournissant une mesure de température de l'air extérieur.

12. Procédé de commande d'un système d'appoint selon l'une des revendications précédentes, **caractérisé en ce que** les pompes à chaleur sont enclenchées successivement en fonction du besoin en chaleur du réseau anergie.

13. Procédé de commande d'un système d'appoint selon l'une des revendications précédentes, **caractérisé en ce qu'**en période de besoin d'énergie de chaleur, les échangeurs de chaleur air-liquide sont connectés directement à l'échangeur de chaleur (10a) du réseau anergie (2) quand la température de l'air extérieur est supérieure à zéro et supérieure à la température mesuré du fluide caloporteur qui circule dans le réseau anergie (2).
